# EUROPÄISCHE PATENTANMELDUNG

(11) **EP 1 981 318 A1**
(43) Veröffentlichungstag der Anmeldung: **15.10.2008**
(21) Anmeldenummer: 08100185.1
(22) Anmeldetag: 08.01.2008
(51) Int. Cl.: H05K 1/14, G01D 11/24

(54) **Funktionseinheit für einen optoelektronischen Sensor und Verfahren zur Anbringung einer Leiterplatte**

(30) Priorität: 13.04.2007 DE 102007017917
(71) Anmelder: SICK AG, 79183 Waldkirch (DE)
(72) Erfinder: Hug, Gottfried, 79183 Waldkirch (DE); Borchardt, Martin, 79183 Waldkirch (DE)
(74) Vertreter: Hehl, Ulrich

(57) **Zusammenfassung**

Es wird eine Funktionseinheit (10) für einen optoelektronischen Sensor (100) mit einem Trägerkörper (12) und einer Leiterplatte (14) angegeben, die einen starren Hauptbereich (16) und einen gegenüber dem Hauptbereich (16) abgewinkelten starren Nebenbereich (18) mit einem flexiblen Verbindungsbereich (20) dazwischen aufweist, wobei in dem Hauptbereich (16) mindestens ein optoelektronisches Element (36, 38) angeordnet ist. Dabei ist der Hauptbereich (16) derart fest mit dem Trägerkörper (12) verbunden, dass die Lage der optoelektronischen Elemente (36, 38) gegenüber dem Trägerkörper (12) festgelegt ist, und der Nebenbereich (18) mit dem Trägerkörper (12) flexibel mit Spiel verbunden ist. Ferner ist ein Sensor (100) mit einer derartigen Funktionseinheit (10) sowie ein entsprechendes Verfahren zur Anbringung einer Leiterplatte (14) an einem Trägerkörper (12) angegeben.

## Beschreibung

Die Erfindung betrifft eine Funktionseinheit für einen optoelektronischen Sensor nach dem Oberbegriff von Anspruch 1 und ein Verfahren zur Anbringung einer Leiterplatte an einen Trägerkörper einer Funktionseinheit eines optoelektronischen Sensors.

Optoelektronische Sensoren werden für eine Vielzahl von Überwachungsaufgaben eingesetzt. Beispiele solcher Sensoren sind Lichtschranken, bei denen ein Lichtsender einen Lichtstrahl aussendet, der von einem gegenüberliegenden Lichtempfänger oder, im Falle einer Reflexionslichtschranke, reflektiert und von einem neben dem Lichtsender angeordneten Lichtempfänger aufgefangen wird. Ein anderer Sensortyp ist ein Lichtgitter, bei dem eine Reihe von Lichtsender/-empfängerpaaren nebeneinander angeordnet sind und eine Art Lichtvorhang bilden.

Eine weitere Anwendung der genannten Sensoren ist die optische Bestimmung einer Entfernung nach dem Prinzip des Lichtlaufzeitverfahrens. Ein dem Lichtstrahl aufgeprägtes Sendemuster wird von einem Objekt reflektiert und nach Empfang in dem Sensor mit einem intern erzeugten Referenzmuster verglichen. Daraus lässt sich der Lichtweg und damit auch der Abstand errechnen. In der Praxis werden im Wesentlichen zwei Verfahren angewandt. Bei dem einen Verfahren ist das Sendemuster ein einfacher Lichtpuls, dessen Laufzeit gemessen wird. Bei dem anderen Verfahren ist das Sendemuster eine Sinusmodulation, wobei die Phasenlage des Sinus gegenüber einem Referenzsinus modulo der Periode des Sinus der Laufzeit entspricht.

Die Entfernungsmessung kann beispielsweise in der Fahrzeugsicherheit, der Logistik- oder Fabrikautomatisierung oder der Sicherheitstechnik benötigt werden. Insbesondere kann ein Entfernungsmesser, der auf einem reflektierten Lichtstrahl basiert, auf eine Entfernungsänderung des Reflektors oder des reflektierenden oder remittierenden Ziels reagieren. Eine besondere Anwendung ist eine Reflexionslichtschranke, bei welcher der Abstand zwischen Lichtsender und Reflektor überwacht wird.

Für die Montage- und Gehäusekonzepte solcher Sensoren gilt es, eine schnellstmögliche und einfache Montage zu gewährleisten, um die Herstellungskosten gering zu halten. Dennoch sollen die Systeme ausreichende Stabilität bieten, um den auftretenden Umweltbelastungen standzuhalten. Eine weitere Anforderung ist, dass zunehmend kleinere Sensoren gefragt werden, so dass Gehäuse und Funktionsbausteine immer weiter miniaturisiert werden.

Es ist dem Stand der Technik bekannt, eine Leiterplatte aus zwei starren Bereichen mit einem flexiblen Mittelbereich zu verbinden, um die Leiterplatte abgewinkelt einzusetzen. Dafür gibt es eine recht aufwändige Lösung, so genannte Starrflexplatinen, bei denen der Mittelbereich aus einem flexiblen Kunststoff wie Polyimid besteht und in einem eigenen Fertigungsschritt zwischen den beiden starren Bereichen angebracht werden muss. Eine kostengünstigere Lösung ist, die beiden starren Bereiche aus einer gemeinsamen Leiterplatte herzustellen und Material im Mittelbereich durch Abspanen abzutragen, bis nur noch eine dünne und flexible Schicht übrig bleibt.

Weiterhin ist für die Fixierung einer Leiterplatte an einem Gehäuse oder einem Träger aus Kunststoff eine Reihe von Aufbautechniken bekannt. Dazu zählt Ultraschallschweißtechnik, eine Verformung unter Wärmebehandlung, Schnappsysteme oder Kleben. Alle diese Fixierungen haben Nachteile, sei es der verhältnismäßig hohe Aufwand oder die Tatsache, dass die Fixierung ungenau oder nicht zu Reparaturzwecken lösbar ist. Techniken, bei denen die Verbindung lösbar ist, beispielsweise Gewindeeinsätze, sind oft mit hohen Kosten verbunden. Die Variabilität verschiedener Einsatzmöglichkeiten eines Gehäusekonzepts nach dem Stand der Technik ist eingeschränkt, wenn die Verbindungstechniken gezielt auf bestimmte Teile ausgelegt werden.

Es ist daher Aufgabe der Erfindung, eine platzsparende, zugleich flexible und dennoch sicher justierte Anbringungsmöglichkeit einer Leiterplatte in einem Sensor anzugeben.

Diese Aufgabe wird durch eine Funktionseinheit gemäß Anspruch 1, einen Sensor gemäß Anspruch 11 und ein Verfahren zur Anbringung einer Leiterplatte gemäß Anspruch 19 gelöst. Die erfindungsgemäße Lösung hat den Vorteil, dass einerseits der Hauptbereich mit seinen sehr genau zu justierenden optoelektronischen Elementen ohne Toleranzen verbunden wird und gleichzeitig die unvermeidlichen Fertigungstoleranzen von Trägerkörper und Leiterplatte, vor allem aber eines externen Anschlusses für Strom oder Signale oder eines Schutzgehäuses über den Nebenbereich ausgeglichen werden können. Somit kann eine abgewinkelte Leiterplatte, die besonders platzsparend ist, ohne Verlust der Genauigkeit der Justierung des optischen Elements verwendet werden. Die so erhaltene Funktionseinheit erfüllt bereits für sich die volle Funktionalität eines Sensors, so dass ein Test und ein Austausch stattfinden kann, ohne dass ein verschweißtes Außengehäuse mühsam geöffnet oder, wenn dies zerstörungsfrei nicht möglich ist, im Reparatur- und Fehlerfall der ganze Sensor weggeworfen werden muss.

Bevorzugt weist die feste Verbindung zwischen Hauptbereich und Trägerkörper mindestens eine selbstfurchende Quetschschraube auf. Diese Art der Anbringung fixiert die Leiterplatte besonders genau auf dem Trägerkörper, ist aber dennoch im Gegensatz zu Kleben oder Ultraschallschweißen lösbar und im Gegensatz zu Schnappsystemen präzise und rutschfest. Im Gegensatz zu einer herkömmlichen Schraube muss kein Gewinde vorgesehen sein, das aufwändig anzubringen wäre. Schließlich ist diese Anbringungsart auch nicht thermisch, so dass ein Verziehen durch Temperaturänderungen nach dem Anbringvorgang vermieden wird.

Vorteilhafterweise weist die flexible Verbindung zwischen Nebenbereich und Trägerkörper mindestens einen Schnapphaken auf. Diese Art der Verbindung ist lösbar, und für den Nebenbereich ist eine gewisse Beweglichkeit zum Aufnehmen von Toleranzen im Gegensatz zu der festen Anbringung des Hauptbereichs gewünscht.

Bevorzugt weist der Verbindungsbereich Polyimid auf oder ist durch Abspanen des Leiterplattenmaterials hergestellt. Die erste Variante ist aufwändiger, dafür kann der Verbindungsbereich häufig geknickt werden, ohne zu brechen. Die zweite Variante ist wesentlich kostengünstiger, und wenn die Leiterplatte nur einmal bei der Monta ge geknickt wird, ist es unerheblich, dass sie nur eine begrenzte Anzahl von Knickvorgängen ohne Beschädigung übersteht.

Vorteilhafterweise hat der Trägerkörper im Wesentlichen die Gestalt eines flachen Quaders, und der Hauptbereich ist an einer langen Seitenfläche, der Nebenbereich an einer kurzen Seitenfläche des Trägerkörpers angeordnet. Ein solcher Trägerkörper liefert eine flache, kompakte Funktionseinheit, die zu einem kleinen Sensor führt. Die rechtwinklige Anordnung der Leiterplatte spart Platz und lässt dem optischen Element und seinem Abstrahl- oder Auffangbereich genügend Raum. Die Lage der Leiterplatte ist störungstechnisch besonders günstig.

Bevorzugt weist der Trägerkörper Führungsstifte auf, um die Funktionseinheit in einem äußeren Gehäuse auszurichten. Auf diese Weise ist auch das optische Element in dem äußeren Gehäuse richtig ausgerichtet.

In einer bevorzugten Ausführungsform sind als optoelektronische Elemente mindestens ein Lichtsender und mindestens ein Lichtempfänger vorgesehen. Die Funktionseinheit kann auf diese Weise als Lichttaster, wie eine tastende Lichtschranke, oder als Entfernungsmesser eingesetzt werden. Durch die besondere Anbringung sind Lichtsender und Lichtempfänger von vorneherein richtig zueinander justiert.

Bevorzugt weist der Nebenbereich eine Anschlusseinheit mit einem Anschlussbereich für eine Stromversorgungseinheit auf. Auf diese Weise ist die Stromversorgung mit ihren Störsignalen räumlich von den empfindlichen optoelektronischen Elementen getrennt. Da sich eine externe Belastung wie ein Zug auf ein Stromversorgungskabel nicht immer vermeiden lässt, ist es auch besser, die Verbindung mit dem flexibel angebrachten Nebenbereich statt dem starren und justageempfindlichen Hauptbereich vorzunehmen.

Bevorzugt ist als Leiterplatte eine Mehrschichtplatine. Damit lässt sich zusätzlich zu der abgewinkelten Form auch noch dadurch Platz sparen, dass beide Hauptflächen der Platine voll genutzt und untereinander verschaltet werden können.

Vorteilhafterweise weist der Verbindungsbereich die gleiche Breite auf wie die Leiterplatte. Dies dient nicht nur der mechanischen Stabilität, sondern ist auch störungstechnisch günstig. Es wird dadurch ermöglicht, einen Großteil des Verbin dungsbereichs auf Masse zu legen und somit die Anfälligkeit für elektromagnetische Störstrahlung in dem Verbindungsbereich erheblich zu reduzieren.

In vorteilhafter Weiterbildung der Erfindung ist die Funktionseinheit in einen Sensor eingesetzt, der ein Gehäuse und eine den optoelektronischen Elementen zugehörige Optik aufweist. Die Optik führt den optoelektronischen Elementen Empfangslicht zu oder bündelt gesendetes Licht, während ein Gehäuse den Einsatz des Sensors unter realistischen Umweltbedingungen schützt.

Bevorzugt weist das Gehäuse Führungslaschen auf, die mit den Führungsstiften in Eingriff kommen, um die Funktionseinheit in einer Ebene innerhalb des Gehäuses festzulegen. Da die Leiterplatte erfindungsgemäß gegenüber dem Trägerkörper in richtiger Justierung für die optoelektronischen Elemente befestigt ist, überträgt sich diese richtige Anordnung auf diese Weise auch auf die Lage innerhalb des Gehäuses.

Vorteilhafterweise verbindet ein Gerätestecker den Nebenbereich mit dem Gehäuse und fixiert somit die Leiterplatte gegenüber dem Gehäuse und dem Trägerkörper. Der ohnehin notwendige Stromanschluss wird auf diese Weise genutzt, um die Funktionseinheit in dem Sensor am richtigen Ort festzuhalten.

Bevorzugt ist ein Gehäusedeckel vorgesehen, der nach Aufnahme der Funktionseinheit auf das Gehäuse aufgesetzt wird und die Funktionseinheit in einer Höhenrichtung festlegt. Damit ist auch die Justierung in dieser Dimension gesichert.

Vorteilhafterweise wird der Gehäusedeckel per Ultraschallschweißen mit dem Gehäuse verbunden. Dies ist eine zuverlässige und kostengünstige Art, das Sensorgehäuse zu schließen.

In einer vorteilhaften Ausführungsform ist die Leiterplatte derart orientiert, dass sie in einer bevorzugten Anbringung des Sensors an einer Wand senkrecht zu dieser Wand steht. Die Leiterplatte bietet somit die geringstmögliche Fläche gegenüber der Wand, die zu unerwünschten kapazitiven Effekten führen würde, und minimiert auf diese Weise elektromagnetische Störungen.

Dabei ist besonders vorteilhaft, wenn Bohrlöcher zur Befestigung des Sensors an der Wand vorgesehen sind, bei deren Nutzung der Sensor in der bevorzugten An bringung an der Wand angeordnet ist. Dann muss nicht mehr der Benutzer darauf achten, wie der Sensor für besonders gutes elektromagnetisches Verhalten anzubringen ist, sondern dies geschieht automatisch.

Bevorzugt ist die Leiterplatte zu dem Gehäuse beabstandet in dem Gehäuse angeordnet. Damit werden Kapazitäten verringert, die sich zwischen der Leiterplatte und der Gehäusewand bzw. eine Wand aufbauen, an der das Gehäuse montiert ist. Der Sensor ist damit deutlich unanfälliger gegen elektromagnetische Störungen.

Das erfindungsgemäße Verfahren kann auf ähnliche Weise durch weitere Merkmale ausgestaltet werden und zeigt dabei ähnliche Vorteile. Derartige weitere Merkmale sind beispielhaft, aber nicht abschließend, in den sich anschließenden Unteransprüchen beschrieben.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:

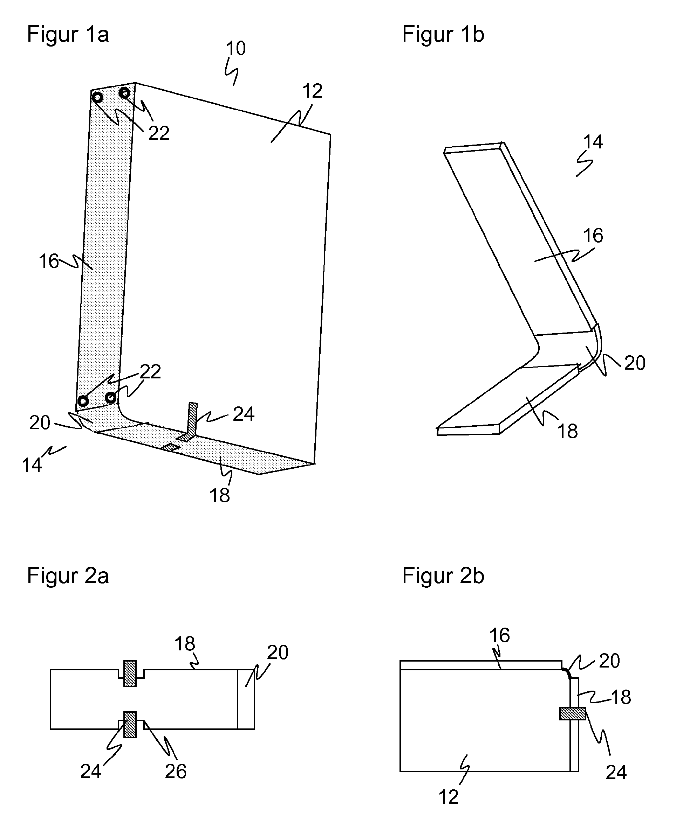

- Fig. 1a: eine vereinfachte dreidimensionale Schemadarstellung einer Ausführungsform einer erfindungsgemäßen Funktionseinheit mit einer abgewinkelten Leiterplatte auf einem Trägerkörper;
- Fig. 1 b: eine dreidimensionale Ansicht allein der abgewinkelten Leiterplatte;
- Fig. 2a: eine Vorderansicht eines Nebenbereichs der Leiterplatte zur Illustrationen der flexiblen Verbindung mit dem Trägerkörper;
- Fig. 2b: ein Querschnitt der Darstellung gemäß Figur 2a;
- Fig. 3: ein Querschnitt durch den Nebenbereich der Leiterplatte und ein Anschlussstück zu Stromversorgung;
- Fig. 4: eine schematische Draufsicht auf eine Ausführungsform der erfindungsgemäßen Funktionseinheit, die in ein Gehäuse eingesetzt ist, um einen erfindungsgemäßen optoelektronischen Sensor zu bilden;
- Fig. 5a: eine dreidimensionale Darstellung analog Figur 1a einer besonderen Ausführungsform der erfindungsgemäßen Funktionseinheit mit Leiterplatte;
- Fig. 5b: eine dreidimensionale Darstellung analog Figur 1b der besonderen Ausführungsform einer Leiterplatte;
- Fig. 6: eine dreidimensionale Darstellung der besonderen Ausführungsform zur Illustration der flexible Verbindung von Nebenbereich und Trägerkörper mit zwei Schnapphaken;
- Fig.7: eine dreidimensionale Schnittdarstellung des Anschlussbereichs der besonderen Ausführungsform;
- Fig. 8a: eine Darstellung der besonderen Ausführungsform zur Illustration der Führungsstifte und Führungslaschen zur Fixierung der Funktionseinheit in einem äußeren Gehäuse des Sensors;
- Fig. 8b: eine Darstellung der besonderen Ausführungsform zur Illustration der Fixierung der Funktionseinheit durch einen Gehäusedeckel; und
- Fig. 9: eine dreidimensionale Darstellung, welche die besondere Ausführungsform des Sensors in Gänze zeigt.

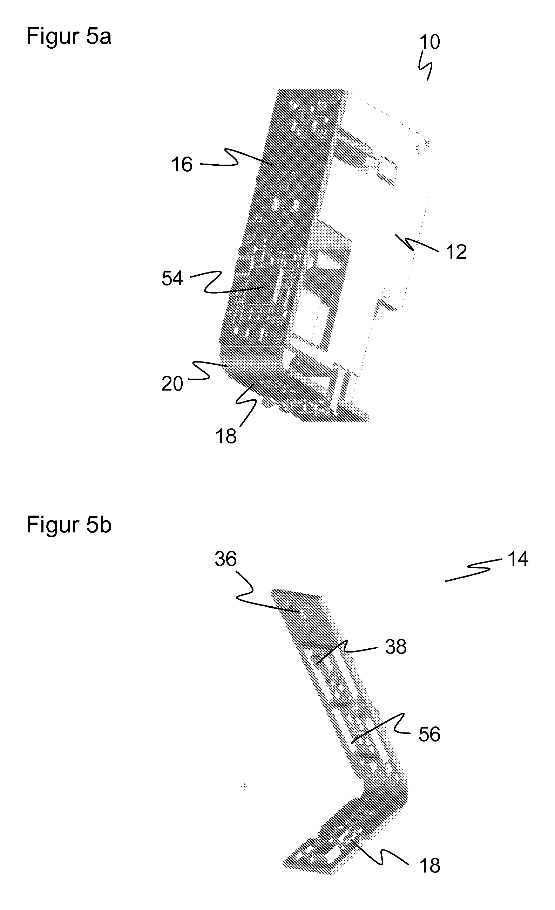

Figur 1a zeigt eine erfindungsgemäße Ausführungsform einer Funktionseinheit 10 für einen optoelektronischen Sensor. Auf einem vorzugsweise aus Kunststoff bestehenden Trägerkörper 12 ist eine Leiterplatte 14 angeordnet, die in der Darstellung grau schattiert ist. Der Trägerkörper 12 ist sehr vereinfacht als Quader dargestellt. Er weist in der Realität Strukturen auf, etwa um Linsen aufzunehmen oder Tuben zu bilden, wie dies beispielsweise in Figur 5a für eine besondere Ausführungsform zu erkennen ist. Die Leiterplatte 14 besteht aus einem starren Hauptbereich 16, einem starren Nebenbereich 18 und einem flexiblen Verbindungsbereich 20. Die Leiterplatte 14 ist in Figur 1b noch einmal isoliert dargestellt; in allen Figuren bezeichnen gleiche Bezugszeichen die gleichen Merkmale.

Auf der Leiterplatte 14 sind im Hauptbereich 16 optoelektronische Elemente, beispielsweise Lichtsender oder Lichtempfänger, angebracht. Der Nebenbereich 18 weist Schaltungselemente und einen Anschluss zur Stromversorgung der Leiterplatte auf. Neben den genannten Elementen ist auf der Leiterplatte 14 Steuerungselektronik vorgesehen, beispielsweise in Form eines programmierbaren Logikbausteins, wie einem FPGA, eines Mikroprozessors oder ASIC, in Form von elektronischen Verstärkern oder Filtern und jeder sonst denkbaren elektrischen Einheit.

Der flexible Verbindungsbereich 20 ermöglicht, dass die Leiterplatte rechtwinklig abgewinkelt an dem Trägerkörper 12 angebracht werden kann, denn in dem Verbindungsbereich 20 sind Verbindungsleitungen zwischen den Schaltelementen von Hauptbereich 16 und Nebenbereich 18 vorgesehen. Die Leiterplatte 14 ist mehr schichtig, und der Verbindungsbereich 20 kann sowohl eine oberste wie auch innere Schichten von Hauptbereich 16 und Nebenbereich 18 miteinander verbinden.

Der Verbindungsbereich 20 ist in etwa oder genau so breit wie der Hauptbereich 16 und der Nebenbereich 18, um einerseits mechanische Stabilität der Verbindung zu gewährleisten und andererseits um die Effizienz als Antenne für elektromagnetische Störungen gering zu halten. Dies wird erreicht, indem ein Großteil des Verbindungsbereichs 20 auf Masse gelegt ist und nur ein kleiner Teil für die notwendigen elektrischen Verbindungen zwischen Hauptbereich 16 und Nebenbereich 18 auf Spannung liegt.

Die Herstellung des flexiblen Verbindungsbereichs 20 kann auf zumindest zwei Arten geschehen: bei einer sogenannten Starrflexplatine werden eine oder mehrere Lagen Polyimid zwischen Hauptbereich 16 und Nebenbereich 18 angebracht. Dies erfordert eigene Herstellungsschritte und ist relativ aufwändig. Alternativ beginnt man mit einer durchgehenden Platine, und der Zwischenbereich zwischen Hauptbereich 16 und Nebenbereich 18, der aus demselben Basismaterial besteht wie der Rest der Platine, wird durch einen spanenden Fertigungsprozess bearbeitet, bis er extrem dünn ist und somit seine Flexibilität erreicht. Dieses Verfahren ist wesentlich kostengünstiger, und der Nachteil der geringeren Langlebigkeit bei mehrfachem Knicken fällt kaum ins Gewicht, weil die Leiterplatte 14 nur einmal geknickt und dann an dem Trägerkörper 12 angebracht wird.

Entsprechend den unterschiedlichen Anforderungen ist die Anbringung des Hauptbereichs 16 von der Anbringung des Nebenbereichs 18 an den Trägerkörper 12 verschieden. Der Hauptbereich 16, welcher die optoelektronische Einheit mit optoelektronischen Elementen ist, muss fix und toleranzarm positioniert werden, denn, wie später noch erläutert, legt der Trägerkörper 12 auch die Position einer Optik fest, der gegenüber die optoelektronischen Elemente der Leiterplatte 14 sehr genau justiert sein müssen. Deshalb ist die Verbindung des Hauptbereichs 16 mit dem Trägerkörper 12 starr, und auch Positionsveränderungen unter thermischer oder mechanischer Belastung müssen minimal bleiben. Dies wird bevorzugt durch selbstfurchende Quetschschrauben 22 erreicht, die das Material des Trägerkörpers 12 verdrängen, wobei sich dieses verdrängte Material sehr eng an die Quetschschraube 22 anschmiegt und sich somit eine sehr genaue und stabile Fixierung des Hauptbereichs 16 der Leiterplatte 14 ergibt.

Andererseits sorgt eine starre Fixierung zwischen Leiterplatte 14 und Trägerkörper 12 für Spannungen, denn unvermeidliche Fehlertoleranzen bei der Herstellung von Leiterplatte 14 und Trägerkörper 12 sorgen für Größenabweichungen und verhindern eine völlige Passgenauigkeit. Die Funktionseinheit 10 soll außerdem in einen Sensor eingebaut werden und muss deshalb mit äußeren Leitungen zur Stromversorgung oder Datenübertragung verbunden werden. Schließlich weist ein Sensor üblicherweise auch ein Schutzgehäuse auf, in das die Funktionseinheit 10 wegen Fertigungstoleranzen nicht ohne weiteres mit einer Passgenauigkeit eingesetzt werden kann, welche die erforderliche hochgenaue Justierung der optoelektronischen Elemente sicherstellt.

Deshalb ist nur der Hauptbereich 16 starr mit dem Trägerkörper 12 verbunden. Der Nebenbereich 18, an dem auch ein äußerer Anschluss vorgesehen ist, wird dagegen flexibel mit Spiel mit dem Trägerkörper 12 verbunden, um zum Ausgleich der Fertigungstoleranzen eine gewisse Beweglichkeit zu erhalten. Der Nebenbereich 18 kann auf diese Weise zum Ausgleich von Toleranzen gegenüber einem Anschluss und einem äußeren Gehäuse ausgerichtet werden. Die dafür notwendige Bewegung gleicht der flexible Verbindungsbereich 20 aus, so dass die starre Verbindung des Hauptbereichs 16 mit dem Trägerkörper 12 erhalten bleibt, die allein für die optische Justierung wichtig ist.

Die flexible Verbindung zwischen Nebenbereich 18 und Trägerkörper 12 ist durch zwei Schnapphaken 24 realisiert. Die Lage dieser Schnapphaken 24 ist in einer von der Ansicht des Nebenbereichs 18 gemäß Figur 2a und einer entsprechenden Schnittdarstellung gemäß Figur 2b gut zu erkennen. Der Nebenbereich 18 weist Ausbuchtungen 26 zur Aufnahme der Schnapphaken 24 auf. Diese Ausbuchtungen 26 sind absichtlich größer als die Schnapphaken 24, um auch in der entsprechenden Richtung Spiel zu lassen, Außerdem sind die Schnapphaken 24 zumindest ein wenig flexibel, um geringe Bewegungen auch in Querrichtung zuzulassen.

Die beschriebene Funktionseinheit 10 ist, wenn der Trägerkörper 12 mit einer Optik und die Leiterplatte 14 mit der notwendigen Elektronik versehen ist, für sich vollständig funktional und kann ohne äußeres Gehäuse betrieben werden. Stellt sich ein Defekt heraus, etwa bei einem Funktionstest während der Herstellung, so kann der Hauptbereich 16 durch Lösen der Quetschschrauben 22 und der Nebenbereich 18 durch Öffnen der Schnapphaken 24 und folglich die ganze Leiterplatte 14 beschädigungsfrei von dem Trägerkörper 12 gelöst werden. Dies ermöglicht Austausch und Reparatur.

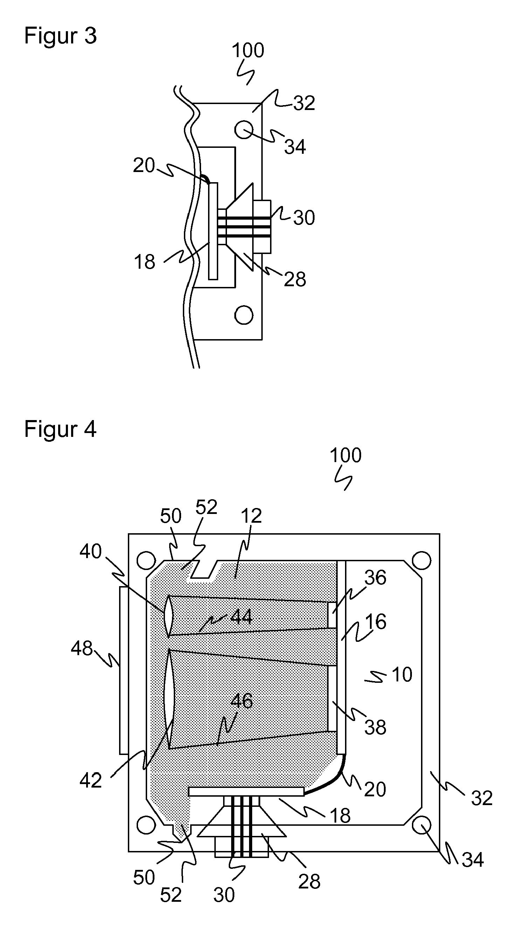

Figur 3 zeigt einen Ausschnitt eines Sensors 100, in den die Funktionseinheit 10 eingebaut ist. Ein Anschlussstecker 28 mit Stromversorgungs- und/oder Datenleitungen 30 ist durch ein äußeres Gehäuse 32 des Sensors 100 geführt und mit dem Nebenbereich 18 verbunden, um die Leiterplatte 14 anzuschließen. Durch diesen Anschluss wird der Nebenbereich 18 gegenüber dem Gehäuse 32 fixiert. Der Anschlussstecker 28 wird dabei durch das Gehäuse 32 positioniert. Auch diese Anschlussverbindung ist lösbar und eine Reparatur durch Entfernen des Anschlusssteckers 28 jederzeit möglich.

Das Gehäuse 32 weist Bohrlöcher 34 auf, um den Sensor 100 an einer Wand zu montieren. Bei Montage unter Verwendung dieser Bohrlöcher 34 steht die Leiterplatte 14 senkrecht zur Wand und bietet der Wand damit nur eine sehr kleine Fläche. Damit wird vermieden, dass sich eine Kapazität aufbaut, und nur eine kleinstmögliche Antennenfläche angeboten wird. Diese Anordnung der Leiterplatte 14, nämlich im Normalfall senkrecht zur Wand, ist damit für möglichst geringe elektromagnetische Störungen optimal. Das wird noch durch die besondere Lage der Leiterplatte 14 verstärkt, die nämlich gegenüber der Wand des Gehäuses 32 beabstandet ist und somit Kapazitäten zwischen Leiterplatte und Gehäusewand erheblich verringert werden. Auf das bei gattungsgemäßen optoelektronischen Sensoren sonst übliche Abschirmen durch Metallbleche kann wegen dieser Anordnung der Leiterplatte 14 weitgehend verzichtet werden.

Figur 4 stellt noch einmal den ganzen Sensor 100 und die Lage der Funktionseinheit 10 in dem äußeren Gehäuse 32 des Sensors 100 dar. Auf dem Hauptbereich 16 der Leiterplatte 14 sind als optoelektronische Elemente ein Lichtsender 36, beispielsweise eine Leuchtdiode oder eine Laserdiode sowie ein Lichtempfänger 38, beispielsweise eine Photodiode, angeordnet. Den optoelektronischen Elementen 36, 38 ist jeweils eine Optik 40, 42 zugeordnet, die durch je einen Tubus 44, 46 des Trägerkörpers 12 gehalten werden. Das Licht kann durch eine Frontscheibe 48 des Gehäuses 32 ein- und austreten.

Das Gehäuse 32 weist Führungslaschen 50 und der Trägerkörper 12 entsprechende Führungsstifte 52 auf, die miteinander in Eingriff stehen. Dadurch ist der Trägerkörper 12 in der Zeichnungsebene der Figur 4 innerhalb des Gehäuses 32 fixiert.

Die Fixierung in der nicht dargestellten Höhenrichtung erfolgt durch Anbringung eines Gehäusedeckels. Dieser Gehäusedeckel kann durch Ultraschallschweißen oder lösbar durch eine Schraubverbindung mit dem Gehäuse verbunden werden. Die Verbindung wird erst vorgenommen, wenn die Funktionsfähigkeit des Sensors durch Test der Funktionseinheit 10 sichergestellt ist.

Die Figuren 5 bis 9 stellen eine besondere Ausführungsform des erfindungsgemäßen Sensors 100 dar. In Figur 5a, einer Darstellung analog Figur 1a, sind die Schaltungselemente für den Anschluss an den Nebenbereich 18 sowie eine Steuerung 54 mit einem zentralen FPGA zu erkennen. Die isolierte Darstellung der Leiterplatte 14 gemäß Figur 5b verdeutlicht die Lage von Lichtsender 36 und Lichtempfänger 38 mit abgeschirmter Verstärkungs- und Filterelektronik 56 auf der der Steuerung 54 gegenüberliegenden Hauptfläche der mehrschichtigen Leiterplatte 14, wobei durch deren innere Schichten eine Verbindung zu Lichtsender 36 und Lichtempfänger 38 hergestellt wird.

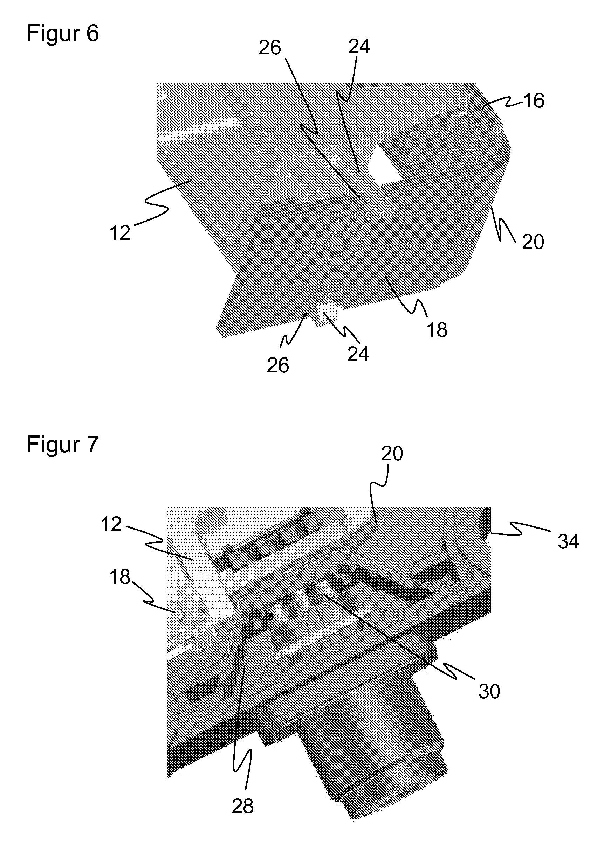

In Figur 6 ist die Halterung des Nebenbereichs 18 mit Schnapphaken 24 dreidimensional dargestellt. Dabei ist das Spiel der Schnapphaken 24 in den breiteren Ausbuchtungen 26 erkennbar.

Figur 7 zeigt in einer dreidimensionalen Querschnittdarstellung die Verbindung zwischen Nebenbereich 18 und Anschlussstecker 28 mit seinen Leitern 30. Durch diesen Anschluss wird der Nebenbereich 18 gegenüber dem Gehäuse 32 fixiert.

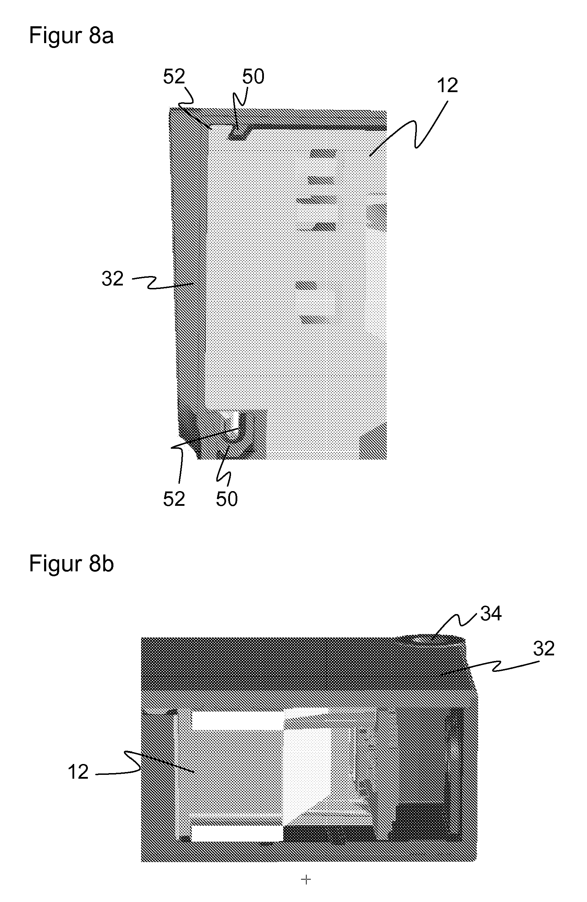

In Figur 8a ist der Eingriff der Führungsstifte 52 des Trägerkörpers 12 in die Führungslaschen 50 des Gehäuses 32 zu erkennen, mit denen die Funktionseinheit 10 in dem Sensor 100 in der Zeichnungsebene festgelegt wird. Figur 8b zeigt die Fixierungsdome des Deckels zur Festlegung des Trägerkörpers 12 in der Höhenrichtung.

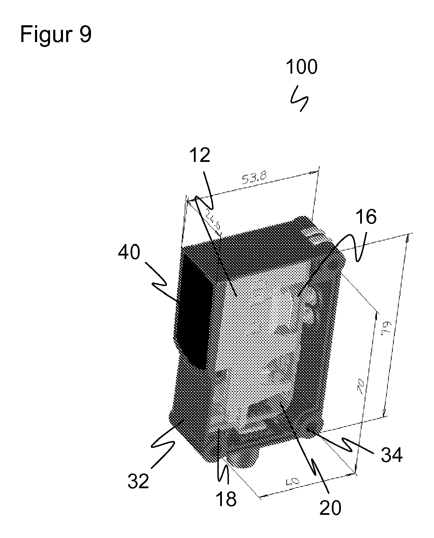

Figur 9 schließlich ist eine dreidimensionale Gesamtdarstellung des geöffneten Sensors 100.

Erfindungsgemäß entsteht eine kostengünstige Funktionseinheit, die stabil und sehr klein ist und die durch Auswechseln Reparaturmöglichkeiten und zugleich auch verschiedenste Sensorvarianten unterstützt. Durch die besondere Anordnung der Leiterplatte 14 ist das gesamte System sehr stabil gegenüber elektromagnetischen Strahlungen, so dass weitgehend auf die sonst üblichen Metallbleche im Gehäuse zur Abschirmung verzichtet werden kann.

## Patentansprüche

1. Funktionseinheit (10) für einen optoelektronischen Sensor (100) mit einem Trägerkörper (12) und einer Leiterplatte (14), die einen starren Hauptbereich (16) und einen gegenüber dem Hauptbereich (16) abgewinkelten starren Nebenbereich (18) mit einem flexiblen Verbindungsbereich (20) dazwischen aufweist, wobei in dem Hauptbereich (16) mindestens ein optoelektronisches Element (36, 38) angeordnet ist, **dadurch gekennzeichnet, dass** der Hauptbereich (16) derart fest mit dem Trägerkörper (12) verbunden ist, dass die Lage der optoelektronischen Elemente (36, 38) gegenüber dem Trägerkörper (12) festgelegt ist, und der Nebenbereich (18) mit dem Trägerkörper (12) flexibel mit Spiel verbunden ist.

2. Funktionseinheit (10) nach Anspruch 1, **dadurch gekennzeichnet, dass** die feste Verbindung zwischen Hauptbereich (16) und Trägerkörper (12) mindestens eine selbstfurchende Quetschschraube (22) aufweist.

3. Funktionseinheit (10) nach Anspruch 1 oder 2, **dadurch gekennzeichnet, dass** die flexible Verbindung zwischen Nebenbereich (18) und Trägerkörper (12) mindestens einen Schnapphaken (24) aufweist.

4. Funktionseinheit (10) nach einem der vorhergehenden Ansprüche, **dadurch gekennzeichnet, dass** der Verbindungsbereich (20) Polyimid aufweist oder durch Abspanen des Leiterplattenmaterials hergestellt ist.

5. Funktionseinheit (10) nach einem der vorhergehenden Ansprüche, **dadurch gekennzeichnet, dass** der Trägerkörper (12) im Wesentlichen die Gestalt eines flachen Quaders hat und wobei der Hauptbereich (16) an einer langen Seitenfläche und der Nebenbereich an einer kurzen Seitenfläche des Trägerkörpers (12) angeordnet ist.

6. Funktionseinheit (10) nach einem der vorhergehenden Ansprüche, **dadurch gekennzeichnet, dass** der Trägerkörper (12) Führungsstifte (52) aufweist, um die Funktionseinheit (10) in einem äußeren Gehäuse (32) auszurichten.

7. Funktionseinheit (10) nach einem der vorhergehenden Ansprüche, **dadurch gekennzeichnet, dass** als optoelektronische Elemente mindestens ein Lichtsender (36) und mindestens ein Lichtempfänger (38) vorgesehen sind.

8. Funktionseinheit (10) nach einem der vorhergehenden Ansprüche, **dadurch gekennzeichnet, dass** der Nebenbereich (18) eine Anschlusseinheit mit einem Anschlussbereich für eine Stromversorgungseinheit (28) aufweist.

9. Funktionseinheit (10) nach einem der vorhergehenden Ansprüche, **dadurch gekennzeichnet, dass** die Leiterplatte (14) eine Mehrschichtplatine ist.

10. Funktionseinheit (10) nach einem der vorhergehenden Ansprüche, **dadurch gekennzeichnet, dass** der Verbindungsbereich (20) die gleiche Breite aufweist wie die Leiterplatte (14).

11. Sensor (100) mit eine Funktionseinheit (10) nach einem der Ansprüche 1 bis 9, der ein Gehäuse (32) und eine den optoelektronischen Elementen (36, 38) zugehörige Optik (40, 42) aufweist.

12. Sensor (100) nach Anspruch 11, wenn rückbezogen auf Anspruch 6, **dadurch gekennzeichnet, dass** das Gehäuse (32) Führungslaschen (50) aufweist, die mit den Führungsstiften (52) in Eingriff kommen, um die Funktionseinheit (10) in einer Ebene innerhalb des Gehäuses (32) festzulegen.

13. Sensor (100) nach Anspruch 11 oder 12, **dadurch gekennzeichnet, dass** ein Gerätestecker (28) den Nebenbereich (18) mit dem Gehäuse (32) verbindet und somit die Leiterplatte (14) gegenüber dem Gehäuse (32) und dem Trägerkörper (12) fixiert.

14. Sensor (100) nach einem der Ansprüche 11 bis 13, **dadurch gekennzeichnet, dass** ein Gehäusedeckel vorgesehen ist, der nach Aufnahme der Funktionseinheit (10) auf das Gehäuse (32) aufgesetzt wird und die Funktionseinheit (10) in einer Höhenrichtung festlegt.

15. Sensor (100) nach einem der Ansprüche 11 bis 14, **dadurch gekennzeichnet, dass** der Gehäusedeckel per Ultraschallschweißen mit dem Gehäuse (32) verbunden wird.

16. Sensor (100) nach einem der Ansprüche 11 bis 15, **dadurch gekennzeichnet, dass** die Leiterplatte (14) derart orientiert ist, dass sie in einer bevorzugten Anbringung des Sensors (100) an einer Wand senkrecht zu dieser Wand steht.

17. Sensor (100) nach Anspruch 16, **dadurch gekennzeichnet, dass** Bohrlöcher (34) zur Befestigung des Sensors (100) an der Wand vorgesehen sind, bei deren Nutzung der Sensor (100) in der bevorzugten Anbringung an der Wand angeordnet ist.

18. Sensor (100) nach einem der Ansprüche 11 bis 17, **dadurch gekennzeichnet, dass** die Leiterplatte (14) zu dem Gehäuse (32) beabstandet in dem Gehäuse (32) angeordnet ist.

19. Verfahren zur Anbringung einer Leiterplatte (14) an einem Trägerkörper (12) einer Funktionseinheit (10) eines optoelektronischen Sensors (100), wobei ein starrer Hauptbereich (18) der Leiterplatte (14) mit mindestens einem optischen Element (36, 38) derart fest mit dem Trägerkörper (12) verbunden wird, dass die Lage der optoelektronischen Elemente (36, 38) gegenüber dem Trägerkörper (12) festgelegt ist, und wobei ein gegenüber dem Hauptbereich (16) abgewinkelter starrer Nebenbereich (18) der Leiterplatte (14) mit einem flexiblen Verbindungsbereich (20) dazwischen mit dem Trägerkörper (12) flexibel mit Spiel verbunden wird.
